(19) Europäisches Patentamt / European Patent Office / Office européen des brevets

(11) **EP 2 378 657 A1**

(12) **EUROPEAN PATENT APPLICATION**
published in accordance with Art. 153(4) EPC

(43) Date of publication:
**19.10.2011 Bulletin 2011/42**

(51) Int Cl.:
*H03F 1/02* (2006.01)       *H03F 1/06* (2006.01)
*H03F 1/32* (2006.01)       *H03F 3/24* (2006.01)
*H04B 1/04* (2006.01)

(21) Application number: **09834745.3**

(22) Date of filing: **16.12.2009**

(86) International application number:
**PCT/JP2009/070950**

(87) International publication number:
**WO 2010/073942 (01.07.2010 Gazette 2010/26)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **25.12.2008 JP 2008330710**

(71) Applicant: NEC Corporation
**Minato-ku**
**Tokyo 108-8001 (JP)**

(72) Inventors:
• **KUNIHIRO, Kazuaki**
  **Tokyo 108-8001 (JP)**
• **YAMANOUCHI, Shingo**
  **Tokyo 108-8001 (JP)**
• **TAKAHASHI, Kiyohiko**
  **Tokyo 108-8001 (JP)**

(74) Representative: **Wenzel & Kalkoff**
**Patentanwälte**
**Postfach 73 04 66**
**22124 Hamburg (DE)**

(54) **POWER AMPLIFICATION DEVICE**

(57) A radio frequency amplifier amplifies a modulation signal or its phase modulation signal and outputs the resultant signal. A linear amplifying section adds an output voltage to a power supply voltage supplied to the radio frequency amplifier and negatively feeds back the power supply voltage supplied to the radio frequency amplifier such that the power supply voltage matches the amplitude modulation component of the modulation signal with a predetermined ratio. A control signal generation section detects a direction in which an output current of the linear amplifying section flows and generates a pulse modulation signal according to the direction of the current. A switching amplifying section controls connection and disconnection of a DC current based on the pulse modulation signal as a control signal so as to perform switching amplification for an output signal of the linear amplifying section and supply the resultant signal as the power supply voltage to the radio frequency amplifier. The DC current is supplied to the switching amplifying section.

Fig.3

## Description

TECHNICAL FIELD

The present invention relates to power amplifying devices mainly used for a radio communication transmitter, in particular, to those that can vary a power supply voltage supplied to an amplifier on the basis of an amplitude modulation component of an input signal.

BACKGROUND ART

Radio communication systems such as mobile telephone systems and wireless LANs (Local Area Networks) that have appeared in recent years use modulation formats such as QPSK (Quadrature Phase Shift Keying) and multi-value QAM (Quadrature Amplitude Modulation). In these modulation formats, when a signal changes between symbols, since its waveform is involved in amplitude modulation, the amplitude (envelop) of a radio frequency modulation signal superimposed on a carrier signal of a microwave bandwidth varies time by time. The ratio of the peak power and the average power of the radio frequency modulation signal is referred to as PAPR (Peak-to-Average Power Ratio). When a signal having a large PAPR is amplified with a high linearity that is maintained, a power supply device needs to supply sufficiently large power to an amplifier so as to prevent the waveform of the amplified signal from being distorted with peak power and secure high linearity of the amplified signal. In other words, the amplifier needs to be operated in a large back-off power region that is sufficiently lower than the saturated output power restricted by the power supply voltage.

Generally, since radio frequency amplifiers that amplify a radio frequency signal according to the class A system or class AB system have maximum efficiency nearly at the saturated output power level, if they are operated in the large back-off power region, their average efficiency lowers.

Although the OFDM (Orthogonal Frequency Division Multiplexing) system has been used in the next-generation mobile phone systems, wireless LANs, digital television broadcasts, and so forth, since their PAPR tends to increase, the average efficiency of radio frequency amplifiers lowers further. Thus, it is desired that radio frequency amplifiers operate with high efficiency even in the large back-off power region.

As a system that amplifies a signal in the large back-off region and with wide dynamic range and high efficiency, a power amplifying device referred to as the EER (Envelope Elimination and Restoration) system has been proposed in Non-patent Document 1.

The EER system proposed in Non-patent Document 1 divides an input modulation signal into a phase modulation component and an amplitude modulation component. Thereafter, the phase modulation component with a constant amplitude is inputted to the amplifier in such a manner that phase modulation information is maintained. At this point, the amplifier is always operated at the nearly saturated output power level having the maximum efficiency.

On the other hand, the amplitude modulation component is amplified with high efficiency by a class D amplifier or the like in such a manner that amplitude modulation information is maintained and then supplied as a power supply voltage (modulation power supply) whose output intensity has been modulated.

When the power amplifying device is operated in such a manner, the amplifier is also operated as a multiplier and combines the phase modulation component and amplitude modulation component of the modulation signal and outputs the combined result. Thus, the amplifier can obtain an output modulation signal amplified with high efficiency not in the large back-off power region.

As a system similar to the EER system, the so-called ET (Envelop Tracking) system is also known. This system has been reported for example in Non-patent Document 2 and so forth.

The ET system is the same as the EER system in the structure that uses a class D amplifier or the like that amplifies the amplitude modulation component of the input modulation signal in such a manner that the amplification modulation information is maintained and supplies the resultant signal as a power supply voltage (modulation power supply) whose output intensity has been modulated to the amplifier.

The EER system is different from the ET system in structure in which the former inputs only a phase modulation signal with a constant amplitude to the amplifier so as to operate it at a nearly saturation output power level; while the latter inputs an input modulation signal containing both amplitude modulation component and phase modulation component to the amplifier so as to linearly operate it.

Although the ET system is inferior to the EER system in efficiency because the amplifier of the former linearly operates, since only a bare minimum power based on the amplitude modulation component of the input modulation signal is supplied to the amplifier, the former can have higher efficiency than the structure that supplies a constant power voltage to the amplifier.

In addition, the ET system can be more easily realized than the EER system because the former allows a timing margin, at which the amplitude modulation component and the phase modulation component are combined, to be loose.

The EER system and the ET system ordinarily use a modulation power supply that converts the amplitude modulation component into a pulse modulation signal and performs switching amplification for the pulse modulation signal using a class D amplifier or the like. As a pulse modulation system for the EER and the ET system, the PWM (Pulse Width Modulation) system has been traditionally used; however, Patent Document 1 and Patent Document 2 propose structures that use the delta modulation system (or PDM (Pulse Density Modulation)) that has higher linearity than the foregoing systems. Moreover, in recent years, the sigma delta modulation system and so forth that have a high SNR (Signal to Noise Ratio) have been used as pulse modulation systems.

Relevant standards for radio communication systems such as mobile telephone systems and wireless LANs using digital modulation systems that have appeared in recent years require that ACPR (Adjacent Channel Leakage Power Ratio) and EVM (Error Vector Magnitude) should be suppressed to a predetermined constant value or below.

To satisfy these standards for power amplifying devices according to the EER system and ET system, it is said that the bandwidth in which a pulse modulator and a class D amplifier with which a modulation power supply is provided needs to be at least twice that of a modulation signal. For example, the modulation bandwidth of WCDMA (Wideband Code Division Multiple Access) used in mobile phone systems is around 5 MHz, whereas the modulation bandwidth of IEEE 802.11 a/g used in wireless LANs is around 20 MHz. Generally, it is difficult to switch a large power at high speed and realize a modulation power supply that operates in such a wide bandwidth.

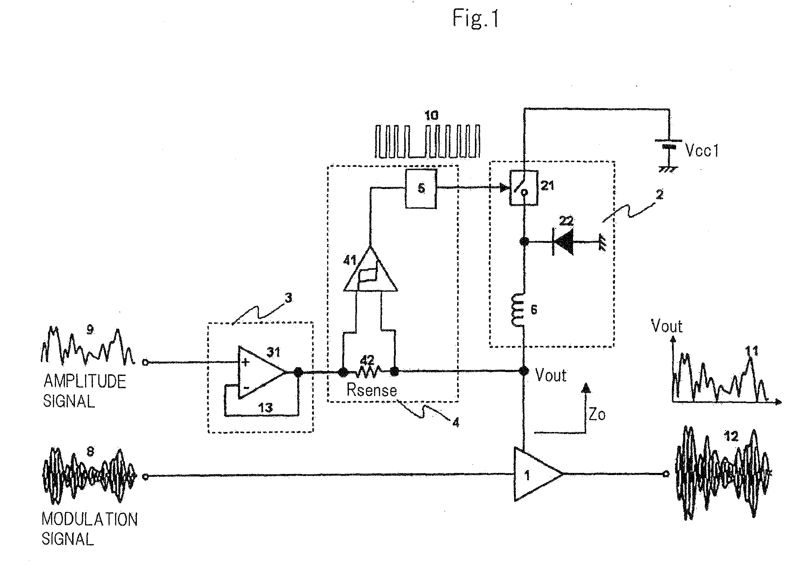

In such a situation, a structure of a modulation power supply that operates with high efficiency and in a wide bandwidth has been proposed in Non-Patent Document 3. The structure of the power amplifying device proposed in Non-Patent Document 3 (hereinafter referred to as the first related art reference) is shown in Fig. 1.

The power amplifying device according to the first related art reference interlocks linear amplifying section 3 that operates in a wide bandwidth, but with low efficiency and switching regulator section 2 that operates in a narrow bandwidth, but with high efficiency so as to supply modulation power (power supply voltage) 11 with high efficiency in a wide bandwidth to amplifier 1.

A specific operation of the power amplifying device is as follows.

Amplitude signal 9 that is an amplitude modulation component of an input modulation signal is inputted to linear amplifying section 3 composed of voltage follower 31 or the like.

An output current of linear amplifying section 3 is converted into a voltage signal by current detection resistor 42 and inputted to hysteresis comparator 41. In this example, if polarities are selected such that when the current flows from linear amplifying section 3, the output voltage of comparator 41 becomes High and when the current flows to linear amplifying section 3, the output voltage of hysteresis comparator 41 becomes Low, a pulse width modulation signal based on the intensity of the input signal is outputted from hysteresis comparator 41.

Gate driver 5 turns on or off switching device 21 composed of, for example, an MOS FET (Metal Oxide Semiconductor Field Effect Transistor) based on the output signal of hysteresis comparator 41. Switching device 21 is comprised of switching regulator section 2 in combination with diode 22; switching regulator section 2 which amplifies the amplitude of the pulse width modulation signal to Vcc1.

The pulse width modulation signal that has been amplified is integrated by inductor 6 and thereby the switching frequency component is removed therefrom.

An error component contained in an output current of inductor 6 is compensated by voltage follower 3 and supplied as a power supply voltage to amplifier 1. At this point, since a current that flows in linear amplifier 31 with low efficiency contains only the error component, the power consumed in linear amplifier 31 is small and most of the signal components of amplitude signal 9 are amplified by switching regulator with high efficiency. Thus, the efficiency of the entire power supply modulator can be improved.

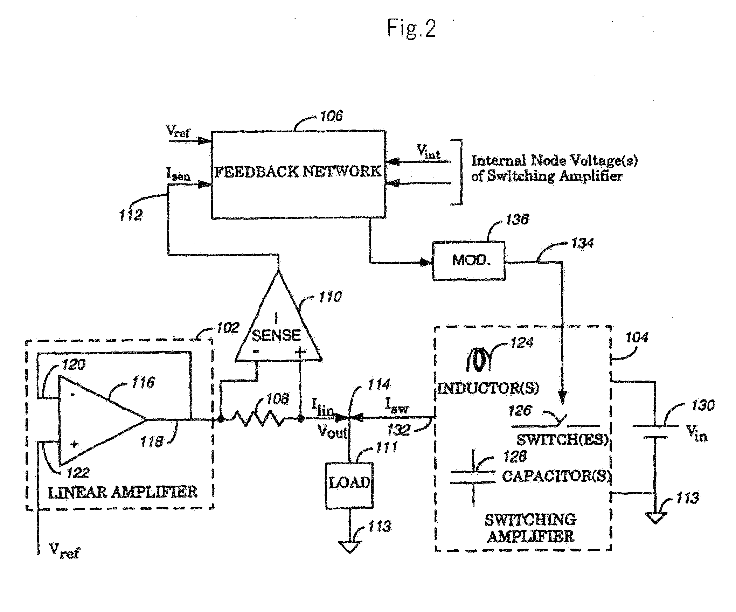

The structure of the power amplifying device proposed in Patent Document 3 (hereinafter referred to as the second related art reference) is shown in Fig. 2.

In the power amplifying device according to the second related art reference as well as that according to the first related art reference, an output current of linear amplifying section 102 is detected by resistor 108, the result is amplified by differential amplifier 110, and then inputted to feedback circuit 106.

Feedback circuit 106 compares an output signal of differential amplifier 110 and reference signal Vref and supplies the compared result typically to pulse modulator 136 that performs pulse width modulation (PWM). Output signal 134 of pulse modulator 136 is inputted to switching amplifying section 104 including at least one switching device 126 and a filter composed of inductor 124 and capacitor 128 so as to control switching device 126.

Output current Isw of switching amplifying section 104 is connected to the output of linear amplifying section 102 through current detection resistor 108. Output voltage Vout of switching amplifying section 104 is compensated by linear amplifying section 102 so as to decrease ripple (switching noise) contained in output current Isw.

Since only a switching noise current ideally flows in linear amplifying section 102, it does not consume large power. Thus, a modulation power supply with high accuracy and high efficiency can be accomplished.

To ideally operate the modulation power supply that supplies power (power supply voltage) to radio frequency amplifier 1 that has been described above, output impedance Zo needs to be sufficiently smaller than the input impedance of the power supply of radio frequency amplifier 1.

Since the power amplifying device according to the first related art reference shown in Fig. 1 structures a modulation power supply by causing linear amplifying section 3 and switching amplifying section 2 to operate in parallel, the output impedance depends on the impedance of the path of linear amplifying section 3 having a lower impedance than the output impedance.

If the gain of linear amplifier 31 is sufficiently high, the output impedance of linear amplifying section 31 gets close to 0.

However, in the structure shown in Fig. 1, since current detection resistor 42 (Rsense) is connected to the output of linear amplifying section 3, the relationship of Zo ≈ Rsense is obtained. Ordinarily, current detection resistor 42 is designated as a value lower than 1Ω, and since the input impedance of the power supply of radio frequency amplifier 1 is as low as around 5Ω, the output impedance cannot be completely ignored.

Since current detection resistor 42 not only causes a deterioration in the efficiency of radio frequency amplifier 1, due to voltage drop, but also causes output voltage Vout of the modulation power supply to slightly deviate from amplitude signal 9 due to voltage drop, noise tends to be superimposed on output voltage Vout, resulting in causing ACPR (Adjacent Channel Leakage Power Ratio) of output signal 12 of radio frequency amplifier 1 not to satisfy the communication standards as a problem of the power amplifying device according to the second related art reference.

In the power amplifying device according to the second related art reference shown in Fig. 2, since linear amplifying section 102 is connected to load 111 (equivalent to an amplifier) through current detection resistor 108, the same problem occurs.

[Citation List]

[Patent Document]

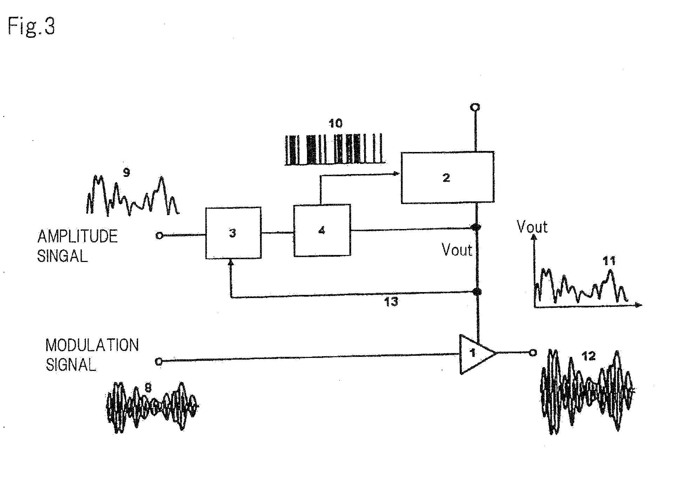

[Patent Document 1] Japanese Patent Laid-Open No. 3207153, (Page 8, Fig. 3)
[Patent Document 2] U.S. Patent No. 5973556, (Page 3, Fig. 3)
[Patent Document 3] U. S. Patent No. 5905407, (Page 2, Fig. 1)

Non-patent Document]

[Non-patent Document 1] Lenard R. Kahn, "Single-sideband Transmission by Envelope Elimination and Restoration", PROCEEDINGS OF THE I. R. E., Vol. 40, pp. 803-806, 1952.
[Non-patent Document 2] J. Staudinger, B. Gilsdorf, D. Newman, G. Norris, G. Sandwniczak, R. Sherman and T. Quach, "HIGH EFFICIENCY CDMA RF POWER AMPLIFIER USING DYNAMIC ENVELOPE TRACKING TECHNIQUE", 2000 IEEE MTT-S Digest, vol. 2, pp. 873-876.
[Non-patent Document 3] F. Wang, A. Ojo, D. Kimball, P Asbeck and L. Larson, "Envelope Tracking Power Amplifier with Pre-Distortion Linearization for WLAN 802.11g", 2004 IEEE MTT-S Digest, vol. 3, pp. 1543-1546.

SUMMARY

An object of the present invention is to provide power amplifying devices that can vary a power supply voltage supplied to an amplifier according to an amplification of a modulation signal, in particular, to those that have high efficiency and high linearity.

To accomplish the foregoing object, an exemplary aspect of the power amplifying device of the present invention is a power amplifying device that amplifies a modulation signal containing an amplitude modulation component and a phase modulation component, comprising:

a radio frequency amplifier that amplifies said modulation signal and outputs the resultant signal;
a linear amplifying section that adds an output voltage to a power supply voltage supplied to said radio frequency amplifier and negatively feeds back the power supply voltage supplied to said radio frequency amplifier such that the power supply voltage matches the amplitude modulation component of said modulation signal with a predetermined ratio;
a control signal generation section that detects a direction in which an output current of said linear amplifying section flows and generates a pulse modulation signal according to the direction of the current;
a switching amplifying section that controls connection and disconnection of a DC current based on said pulse modulation signal as a control signal so as to perform switching amplification for an output signal of said linear amplifying section and to supply the resultant signal as said power supply voltage to said radio frequency amplifier; and
a DC power supply that supplies said DC current to said switching amplifying section.

Alternatively, another exemplary aspect of the power amplifying device of the present invention is a power amplifying device that amplifies a modulation signal containing an amplitude modulation component and a phase modulation component, comprising:

a radio frequency amplifier that amplifies the phase modulation component of said modulation signal and outputs the resultant signal;
a linear amplifying section that adds an output voltage to a power supply voltage supplied to said radio frequency amplifier and negatively feeds back the power supply voltage supplied to said radio frequency amplifier such that the power supply voltage matches the amplitude modulation component of said modulation signal with a predetermined ratio; a control signal generation section that detects a direction in which an output current of said linear amplifying section flows and generates a pulse modulation signal according to the direction of the current; a switching amplifying section that controls connection and disconnection of a DC current based on said pulse modulation signal as a control signal so as to perform switching amplification for an output signal of said linear amplifying section and to supply the resultant signal as said power supply voltage to said radio frequency amplifier; and

a DC power supply that supplies said DC current to said switching amplifying section.

BRIEF DESCRIPTION OF DRAWINGS

[Fig. 1]
Fig. 1 is a block diagram showing a structure of a power amplifying device according to a first related art reference.
[Fig. 2]
Fig. 2 is a block diagram showing a structure of a power amplifying device according to a second related art reference.
[Fig. 3]
Fig. 3 is a block diagram showing an exemplary structure of a power amplifying device according to the present invention.
[Fig. 4]

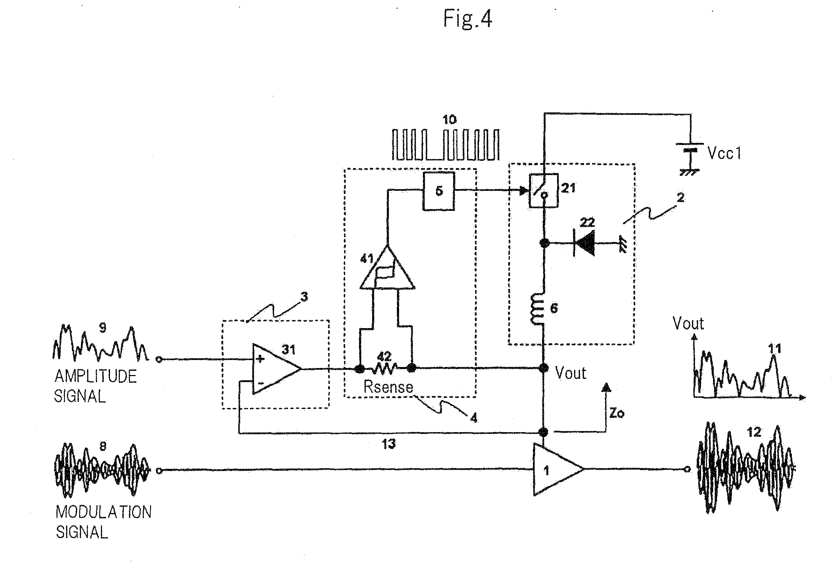

Fig. 4 is a circuit diagram showing a specific exemplary structure of the power amplifying device shown in Fig. 3.
[Fig. 5]

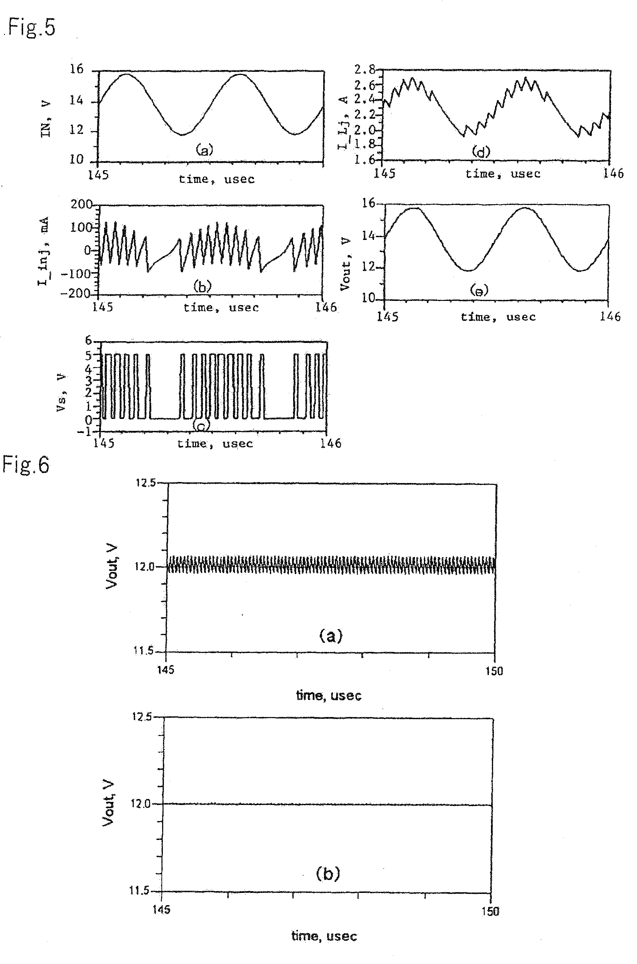

Fig. 5 is a signal waveform diagram showing an exemplary operation of the power amplifying device shown in Fig. 4.
[Fig. 6]
Fig. 6 is a graph showing an exemplary effect of the power amplifying device shown in Fig. 4.

EXEMPLARY EMBODIMENT

Next, with reference to drawings, the present invention will be described.
Fig. 3 is a block diagram showing an exemplary structure of a power amplifying device according to the present invention.
As shown in Fig. 3, the power amplifying device according to this exemplary embodiment is provided with radio frequency amplifier 1, switching amplifying section 2, linear amplifying section 3, and control signal generation section 4.
Linear amplifying section 3 adds the output voltage to a power supply voltage supplied to radio frequency amplifier 1 and negatively feeds back the power supply voltage supplied to radio frequency amplifier 1 such that the power supply voltage matches an amplitude modulation component of modulation signal 8 at a predetermined ratio.
Control signal generation section 4 generates a pulse modulation signal that becomes High or Low depending on the direction of the output current of linear amplifying section 3 and outputs the pulse modulation signal to switching amplifying section 2.
Switching amplifying section 2 performs switching amplification for amplitude signal 9 based on the pulse modulation signal as a control signal that is outputted from control signal generation section 4, adds a predetermined DC voltage to the amplified signal, and outputs the resultant signal. The output voltage of switching amplifying section 2 is added to the output voltage of control signal generation section 4 and thereby modulation voltage 11 is generated as a power supply voltage supplied to radio frequency amplifier 1.
In the power amplifying device according to this exemplary embodiment, modulation voltage 11 that is the power supply voltage supplied to radio frequency amplifier 1 is negatively fed back to linear amplifying section 3.
Radio frequency amplifier 1 linearly amplifies modulation signal 8 according to the class A system or class AB system based on modulation voltage 11 as a power supply and outputs radio frequency modulation signal 12 which has been modulated with respect to amplitude and phase.
Fig.4 is a circuit diagram showing a specific exemplary structure of the power amplifying device shown in Fig. 3.
As shown in Fig. 4, switching amplifying section 2 is provided with switching device 21, diode 22, and inductor 6.
On the other hand, linear amplifying section 3 is provided with linear amplifier 31. Control signal generation section 4 is provided with hysteresis comparator 41, current detection resistor 42, and gate driver 5.
In the power amplifying device according to this exemplary embodiment, linear amplifying section 3 is composed of a linear amplifier (for example, a voltage follower) including a negative feedback loop. Thus, the waveform of the output voltage accords to the waveform of amplitude signal 9 with high accuracy. The output of linear amplifying section 3 is inputted to control signal generation section 4.
Control signal generation section 4 is provided with current detection resistor 42 that detects a current that is outputted from linear amplifying section 3 and a comparator (hysteresis comparator 41) and generates a control signal for example that becomes High when the current flows from linear amplifying section 3 and becomes Low when the current flows thereto. The generated control signal is inputted to switching amplifying section 2.

Switching amplifying section 2 controls connection/disconnection of switching device 21 based on the control signal generated by control signal generation section 4 so as to perform switching amplification for the output signal of linear amplifying section 3.

A current that is outputted from switching amplifying section 2 is smoothened by inductor 6 and added to the output signal of linear amplifying section 3 so as to compensate the voltage.

Modulation voltage 11 that has been compensated is supplied as a power supply voltage to radio frequency amplifier 1 that linearly amplifies modulation signal 8, resulting in always supplying only a bare minimum power (power supply voltage) to radio frequency amplifier 1. Thus, the power amplifying device according to this exemplary embodiment can operate radio frequency amplifier 1 with higher efficiency than the case in which a constant voltage is supplied as a power supply voltage.

Since the output impedance of the modulation power supply is not affected by current detection resistor 42, the power amplifying device according to this exemplary embodiment operates as a more ideal modulation power supply than do the power amplifying devices according to the related art references. Next, this effect will be described by comparing a specific structure (Fig. 4) of this exemplary embodiment with the first related art reference (Fig. 1).

In the power amplifying device according to the first related art reference shown in Fig. 1, output impedance Zo of the modulation power supply viewed from a power supply terminal of radio frequency amplifier 1 can be given by the following formula (1).

[Expression 1]

$$Z_0 = \frac{r_0}{1 + A_0 \beta} + R_{sense} \ ... \ (1)$$

where $r_0$ is the output resistance of linear amplifier 31, $A_0$ is the gain of linear amplifier 31, $\beta$ is the feedback ratio, $\beta = 1$ in the structure shown in Fig. 1.

Generally, since output resistance $r_0$ of linear amplifier (operational amplifier) is sufficiently small and gain $A_0$ is sufficiently large, the first term of the right side of the foregoing formula (1) becomes so small that it can be ignored, namely Zo ≈ Rsense.

On the other hand, output impedance $Z_0$ of the modulation power supply viewed from the power supply terminal of radio frequency amplifier 1 shown in Fig. 4 can be given by the following formula (2).

[Expression 2]

$$Z_0 = \frac{r_0 + R_{sense}}{1 + A_0 \beta} \ ... \ (2)$$

In this case, due to the same reason as the foregoing formula (1), the right side of the formula (2) becomes so small that it can be ignored. In other words, the right side becomes Zo ≈ 0 that denotes that radio frequency amplifier 1 can operate as an ideal modulation power supply.

Thus, since the power amplifying device according to this exemplary embodiment has higher following accuracy for amplitude signal 9 than does the power amplifying devices according to the related art references, the former can realize a modulation power supply having a low switching noise. As a result, radio frequency modulation signal 12 with high linearity can be obtained.

Next, with reference to Fig. 4 to Fig. 6, an operation of the power amplifying device according to this exemplary embodiment will be described.

Fig. 5 is a signal waveform diagram showing an exemplary operation of the power amplifying device shown in Fig. 4; Fig. 6 is a graph showing an exemplary effect of the power amplifying device shown in Fig. 4.

Fig. 5 shows an exemplary operational waveform in the case in which a sine wave having an amplitude of 4 V and a frequency of 2 MHz is inputted as amplitude signal 9, a DC voltage of 12 V is added to amplitude signal 9, and the resultant signal is outputted. Fig. 6 shows output power in the case in which the DC voltage of 12 V is added to amplitude signal 9 compared with that of the first related art reference shown in Fig. 1.

As shown in Fig. 4, amplitude signal 9 that is an amplitude modulation component of modulation signal 8 that has been modulated with respect to amplitude and phase is inputted to linear amplifying section 3.

Linear amplifying section 3 is composed of linear (differential) amplifier 31, typically an operational amplifier, and operates such that the input signal (amplitude signal 9) matches feedback signal 13 (Fig. 5(a)).

An output current (Fig. 5(b)) of linear amplifier 31 is converted into a voltage signal by current detection resistor 42 and then inputted to hysteresis comparator 41. If polarities are selected such that when the current flows from linear amplifier 31, the output voltage of hysteresis comparator 41 becomes High and when the current flows to linear amplifier 31, the output voltage of hysteresis comparator 41 becomes Low, a pulse width modulation signal based on the intensity of the input signal is outputted from hysteresis comparator 41 (Fig. 5(c)).

Gate driver 5 turns on or off switching device 21 composed of, for example, an MOS FET based on the output signal of hysteresis comparator 41.

Power supply voltage Vcc1 is supplied to one terminal of switching device 21 and a cathode of diode 22 of anode ground type and inductor 6 are connected to the other terminal of switching device 21.

When the control signal that is outputted from hysteresis comparator 41 is High, switching device 21 is connected and thereby a current flows from power supply voltage Vcc1 to inductor 6. At this point, if the ON resistance of switching device 21 is so small such that it can be ignored, the potential of a connection node of switching device 21 and diode 22 rises to Vcc1. Thus, since a reverse voltage is applied to diode 22, no current flows.

In contrast, when the control signal that is outputted from hysteresis comparator 41 becomes low, switching device 21 is disconnected and a current that is flowing from voltage source Vcc1 to inductor 6 is blocked.

Since inductor 6 maintains a current that is flowing, a counter electromotive force occurs, resulting in causing the potential of the connection node between switching device 21 and diode 22 to drop. When the potential of the connection node between switching device 21 and diode 22 becomes a negative potential and becomes equal to or lower than a forward voltage of diode 22, a current flows from the ground potential to inductor 6 through diode 22.

In this series of operations, while a current is flowing, since a voltage is not applied between both terminals of switching device 21 and diode 22, switching amplification is performed for the output signal of linear amplifier 31 ideally with an efficiency of 100 %.

The switching amplified current is integrated by inductor 6 and thereby a switching frequency component is removed therefrom (Fig. 5(d)).

In addition, a switching noise component contained in the output voltage of switching amplifying section 2 is compensated (smoothened) by linear amplifier 31 (Fig. 5(e)).

As described above, since the output voltage of switching amplifying section 2 is negatively fed back to linear amplifier 31, it operates such that output voltage Vout of switching amplifying section 2 matches the input signal waveform (amplitude signal 9). Thus, a signal that cancels the switching noise that is contained in switching amplifying section 2 is outputted from linear amplifier 31. Voltage Vout that has been compensated by linear amplifier 31 is supplied to radio frequency amplifier 1.

Radio frequency amplifier 1 linearly amplifies modulation signal 8 that has been inputted based on the power supply voltage that is the output voltage of switching amplifying section 2. At this point, since only a minimum power (power supply voltage) is supplied to radio frequency amplifier 1 based on the amplitude of amplitude signal 9, radio frequency amplifier 1 can always operate nearly with saturation power having high efficiency.

In the power amplifying device according to this exemplary embodiment, as shown in Fig. 5(b), since only a current of a switching noise component flows in linear amplifier 31 with low efficiency, it consumes a small amount of power, resulting in improving the efficiency of the entire power amplifying device.

Moreover, in the power amplifying device according to this exemplary embodiment, since the output voltage of switching amplifying section 2 is negatively fed back to linear amplifier 31, the influence of the potential drop by current detection resistor 42 can be removed from the power supply voltage supplied to radio frequency amplifier 1.

Fig. 6(a) shows an exemplary voltage waveform that is outputted from switching amplifying section 2 of the power amplifying device according to the first related art reference shown in Fig. 1; Fig. 6(b) shows an exemplary voltage waveform that is outputted from switching amplifying section 2 of the power amplifying device shown in Fig. 4.

As shown in Fig. 6(a), in the first related art reference, slight switching noise is superimposed on the output voltage. This denotes that in the power amplifying device according to the first related art reference, since linear amplifier 31 is structured to negatively feed back the output signal, a voltage drop occurs due to current detection resistor 42 and thereby amplitude signal 9 does not perfectly match the waveform of the power supply voltage supplied to radio frequency amplifier 1.

If such slight switching noise enters radio frequency modulation signal 12 that is outputted from radio frequency amplifier 1, normal communication may be affected.

On the other hand, as shown in Fig. 6(b), in the power amplifying device according to this exemplary embodiment, switching noise is removed from the output voltage. This denotes that since the output voltage of switching amplifying section 2 is negatively fed back to linear amplifier 31, current detection resistor 42 is contained in the feedback loop, the output voltage waveform is compensated along with the switching noise component.

Thus, since the switching noise does not enter radio frequency modulation signal 12 that is outputted from radio frequency amplifier 1, normal communication can be performed.

When these effects are rephrased, in the first related art reference shown in Fig. 1, as given by formula (1), the influence of the current detection resistor remains as Zo ≈ Rsense, where Zo is the output impedance of the modulation power supply; in the power amplifying device shown in Fig. 4, since output impedance Zo of the modulation power supply becomes Zo ≈ 0, the power amplifying device operates as a more ideal voltage source.

Although the power amplifying device shown in Fig. 4 is an exemplary structure that operates according to the ET system in which modulation signal 8 containing a phase modulation component and an amplitude modulation component is inputted to radio frequency amplifier 1, this exemplary embodiment can be applied to the EER system in which only a phase modulation component having a constant amplitude of which an amplitude modulation component is removed from modulation signal 8 is inputted to radio frequency amplifier 1.

In addition, the structure of switching amplifying section 2 is not limited to the structure shown in Fig. 4; switching amplifying section 2 may be provided with a switching device instead of diode 22 and the switching device may be turned on and off in synchronization with the output signal of switching amplifying section 2. In this case, the switching device provided instead of diode 22 may be operated in the reverse phase of switching device 21.

Although the power amplifying device shown in Fig. 4 is an exemplary structure in which the feedback ratio (β) to linear amplifying section 3 is 1 and the amplification factor (~ 1/β) of linear amplifying section 3 is 1, linear amplifying section 3 may have a gain of β < 1.

Now, with reference to the exemplary embodiments, the present invention has been described. However, it should be understood by those skilled in the art that the structure and details of the present invention may be changed in various manners without departing from the scope of the present invention.

The present application claims a priority based on Japanese Patent Application No. 2008-330710 filed on December 25, 2008, the entire contents of which are incorporated herein by reference in its entirety.

**Claims**

1. A power amplifying device that amplifies a modulation signal containing an amplitude modulation component and a phase modulation component, comprising:

    a radio frequency amplifier that amplifies said modulation signal and outputs the resultant signal;
    a linear amplifying section that adds an output voltage to a power supply voltage supplied to said radio frequency amplifier and negatively feeds back the power supply voltage supplied to said radio frequency amplifier such that the power supply voltage matches the amplitude modulation component of said modulation signal with a predetermined ratio;
    a control signal generation section that detects a direction in which an output current of said linear amplifying section flows and generates a pulse modulation signal according to the direction of the current;
    a switching amplifying section that controls connection and disconnection of a DC current based on said pulse modulation signal as a control signal so as to perform switching amplification for an output signal of said linear amplifying section and to supply the resultant signal as said power supply voltage to said radio frequency amplifier; and

    a DC power supply that supplies said DC current to said switching amplifying section.

2. A power amplifying device that amplifies a modulation signal containing an amplitude modulation component and a phase modulation component, comprising:

    a radio frequency amplifier that amplifies the phase modulation component of said modulation signal and outputs the resultant signal;
    a linear amplifying section that adds an output voltage to a power supply voltage supplied to said radio frequency amplifier and negatively feeds back the power supply voltage supplied to said radio frequency amplifier such that the power supply voltage matches the amplitude modulation component of said modulation signal with a predetermined ratio;
    a control signal generation section that detects a direction in which an output current of said linear amplifying section flows and generates a pulse modulation signal according to the direction of the current;
    a switching amplifying section that controls connection and disconnection of a DC current based on said pulse modulation signal as a control signal so as to perform switching amplification for an output signal of said linear amplifying section and to supply the resultant signal as said power supply voltage to said radio frequency amplifier; and
    a DC power supply that supplies said DC current to said switching amplifying section.

3. The power amplifying device according to claim 1 or 2,
   wherein said switching amplification section, includes:

    at least one switching device that is controlled based on said pulse modulation signal; and
    a filter device including at least one inductor that smoothens an output signal of said switching device.

4. The power amplifying device according to any one of claims 1 to 3,
   wherein said control signal generation section includes:

    a current detection resistor in which an output current of said linear amplifying section flows; and
    a hysteresis comparator that determines the direction of the output current of said linear amplifying section based on a voltage generated on both ends of said current detection resistor

**EP 2 378 657 A1**

and outputs the determined result as a pulse modulation signal.

Fig.1

Fig.2

Fig.3

Fig.4

Fig.5

Fig.6

| **INTERNATIONAL SEARCH REPORT** | International application No. |
|---|---|
| | PCT/JP2009/070950 |

A. CLASSIFICATION OF SUBJECT MATTER
*H03F1/02*(2006.01)i, *H03F1/06*(2006.01)i, *H03F1/32*(2006.01)i, *H03F3/24* (2006.01)i, *H04B1/04*(2006.01)i

According to International Patent Classification (IPC) or to both national classification and IPC

B. FIELDS SEARCHED

Minimum documentation searched (classification system followed by classification symbols)
H03F1/02, H03F1/06, H03F1/32, H03F3/24, H04B1/04

Documentation searched other than minimum documentation to the extent that such documents are included in the fields searched
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | US 6710646 B1 (Telefonaktiebolaget LM Ericsson),<br>23 March 2004 (23.03.2004),<br>entire text; fig. 1 to 4<br>(Family: none) | 1-3<br>4 |
| Y | JP 2000-227364 A (Toyota Motor Corp.),<br>15 August 2000 (15.08.2000),<br>paragraph [0026]; fig. 4<br>(Family: none) | 4 |
| Y | JP 11-271265 A (Denso Corp.),<br>05 October 1999 (05.10.1999),<br>paragraphs [0047] to [0055]; fig. 1, 4<br>& US 6397659 B1 & GB 2335495 A<br>& GB 9906459 A0 & DE 19912469 A | 4 |

☐ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>   15 January, 2010 (15.01.10) | Date of mailing of the international search report<br>   26 January, 2010 (26.01.10) |
|---|---|
| Name and mailing address of the ISA/<br>   Japanese Patent Office | Authorized officer |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 3207153 B
- US 5973556 A
- US 5905407 A
- JP 2008330710 A

### Non-patent literature cited in the description

- **Lenard R. Kahn.** Single-sideband Transmission by Envelope Elimination and Restoration. *PROCEEDINGS OF THE I. R. E.,* 1952, vol. 40, 803-806
- **J. Staudinger ; B. Gilsdorf ; D. Newman ; G. Norris ; G. Sandwniczak ; R. Sherman ; T. Quach.** HIGH EFFICIENCY CDMA RF POWER AMPLIFIER USING DYNAMIC ENVELOPE TRACKING TECHNIQUE. *IEEE MTT-S Digest,* 2000, vol. 2, 873-876
- **F. Wang ; A. Ojo ; D. Kimball ; P Asbeck ; L. Larson.** Envelope Tracking Power Amplifier with Pre-Distortion Linearization for WLAN 802.11g. *IEEE MTT-S Digest,* 2004, vol. 3, 1543-1546